# EUROPÄISCHE PATENTSCHRIFT

(11) **EP 2 293 315 B1**
(45) Veröffentlichungstag und Bekanntmachung des Hinweises auf die Patenterteilung: **01.10.2014**
(21) Anmeldenummer: 10008025.8
(22) Anmeldetag: 31.07.2010
(51) Int. Cl.: H01H 85/046, H01H 85/10

(54) **Leiterplatte mit Schmelzsicherung und Verfahren zur Herstellung einer Schmelzsicherung**
Melt-resistant conductor board and method for producing melt resistance
Plaque conductrice dotée d'une sécurité contre la fonte et procédé de fabrication d'une sécurité contre la fonte

(30) Priorität: 03.09.2009 DE 102009040022
(43) Veröffentlichungstag der Anmeldung: 09.03.2011
(73) Patentinhaber: BorgWarner BERU Systems GmbH, 71636 Ludwigsburg (DE)
(72) Erfinder: Luppold, Michael, 76706 Dettenheim-Lie. (DE); Dauth, Alexander, 75433 Maulbronn (DE)
(74) Vertreter: Twelmeier Mommer & Partner

(56) Entgegenhaltungen:
- DE-A1-102005 024 321
- US-A1- 2003 048 620
- US-A1- 2005 001 710

## Beschreibung

Die Erfindung betrifft ein Verfahren zum Ausbilden einer Schmelzsicherung, die zwei nebeneinander auf einer Leiterplatte in einem Abstand voneinander angeordnete Metallflächen elektrisch verbindet. Die Erfindung betrifft zudem eine Leiterplatte mit einer solchen Schmelzsicherung. Eine Leiterplatte mit einer Schmelzsicherung, welche die im Oberbegriff des Anspruchs 4 angegebenen Merkmale offenbart, ist aus der US 2005/0001710 A1.

Im Fehlerfall können auf Leitärplatten angeordnete Schaltungen zu extremen Übertemperaturen führen. Zum Schutz werden Schaltungen deshalb in der Regel mit Schmelzsicherungen, Temperaturschaltern, strombegrenzenden PTC-Elementen oder ähnlichen Komponenten ausgerüstet.

Aufgabe der vorliegenden Erfindung ist es, einen Weg aufzuzeigen, wie möglichst kostengünstig und mit möglichst geringem Platzbedarf zuverlässig erreicht werden kann, dass im Fehlerfall ein Laststrom unterbrochen oder zumindest soweit reduziert werden kann, dass Folgeschäden verhindert werden können.

Diese Aufgabe wird durch ein erfindungsgemäßes Verfahren mit den im Anspruch 1 angegebenem Merkmal sowie durch eine Leiterplatte mit einer Schmelzsicherung gemäß Anspruch 4 gelöst. Vorteilhafte Weiterbildungen der Erfindung sind Gegenstand von Unteransprüchen.

Bei einer erfindungsgemäßen Schmelzsicherung wird ein Abstand zwischen zwei nebeneinander auf der Leiterplatte angeordneten Metallflächen mit Weichlotmaterial überbrückt und so ein elektrischer Kontakt zwischen den beiden Metallflächen hergestellt. Das Weichlotmaterial bedeckt dabei jeweils nur einen Teil der Metallflächen. Ein weiterer Teil der Metallflächen in der Umgebung des Weichlotmaterials bildet Aufnahmebereiche, die bei einem Ansprechen der Sicherung geschmolzenes Lotmaterial aufnehmen. Die Grenzflächenenergie zwischen Lotmaterial und den Aufnahmebereichen ist geringer als die Grenzflächenenergie zwischen Lotmaterial und der Leiterplattenoberfläche zwischen den beiden überbrückten Metallflächen. Beim Aufschmelzen des Lotmaterials werden deshalb die Aufnahmebereiche mit flüssigem Lotmaterial benetzt, so dass Lotmaterial aus dem Leiterplattenbereich zwischen den beiden Metallflächen abfließt und der von dem Lotmaterial gebildete elektrische Kontakt unterbrochen wird.

Bei dem erfindungsgemäßen Verfahren werden die Aufnahmebereiche ausgebildet, indem vor dem Aufbringen des Lotmaterials die entsprechenden Bereiche der beiden Metallflächen mit einer lotabweisenden Schutzschicht bedeckt werden. Anschließend wird auf die nicht von der Schutzschicht bedeckten Teilflächen flüssiges Lotmaterial aufgebracht, das den Abstand zwischen den beiden Metallflächen überbrückt. Nach Erstarren des Lotmaterials wird die Schutzschicht in der Umgebung des Lotmaterials entfernt, so dass Aufnahmebereiche entstehen, die mit geschmolzenem Lotmaterial benetzbar sind. Die Schutzschicht kann beispielsweise durch Strahlungseinwirkung entfernt oder abgewaschen werden.

Die Schutzschicht wird bevorzugt durch Lötstopplack gebildet. Möglich ist es aber beispielsweise auch, die Schutzschicht als eine Folie auszubilden ist und durch Abziehen zu entfernen.

Metallisierte Flächen einer Leiterplatte, beispielsweise Metallflächen aus Kupfer, sind wesentlich besser mit Lotmaterial benetzbar als übliche Kunstharzoberflächen von Leiterplatten. Die Grenzflächenenergie zwischen Lotmaterial und Kunstharz, insbesondere Epoxidharz, ist also größer als die Grenzflächenenergie zwischen Lotmaterial und einer Metallfläche, insbesondere Kupfer. Beim Aufschmelzen des Lotmaterials fließt das Lotmaterial deshalb aus dem Leiterplattenbereich zwischen den beiden Metallflächen ab und benetzt die Aufnahmebereiche.

Um die Benetzbarkeit der Aufnahmebereiche zu verbessern sind diese bevorzugt zumindest teilweise mit Flussmittel bedeckt. Geeignet sind insbesondere Flussmittel auf Basis von natürlichen oder modifizierten Harzen, beispielsweise Kolophonium, denen Aktivierungszusätze, beispielsweise Säuren, insbesondere Stearin-, Salicyl- und/oder Adipinsäure zugesetzt sein können. Derartige Flussmittel werden beispielsweise als F-SW 31, F-SW 32, F-SW 33 oder F-SW 34 bezeichnet. Möglich sind auch Flussmittel, die in organischer Zubereitung, beispielsweise höheren Alkohole oder Fetten, Zink- und/oder Ammoniumchlorid enthalten.

Um bei einem Aufschmelzen des Lots eine Unterbrechung des Kontakts zwischen den beiden Metallflächen zu bewirken, genügt es an sich, auf einer Seite des überbrückten Abstandes einen Aufnahmebereich oder Reservoir vorzusehen. Bevorzugt sind jedoch auf beiden Seiten des durch Lotmaterial überbrückten Abstandes Aufnahmebereiche vorgesehen. Dies bedeutet, dass jede der beiden Metallflächen sowohl einen mit Lotmaterial bedeckten Kontaktbereich als auch einen Aufnahmebereich bildet.

Bevorzugt umgibt die wenigstens ein Aufnahmebereich das Lotmaterial, beispielsweise U- oder C-förmig. Auf diese Weise wird erreicht, dass flüssiges Lotmaterial die Aufnahmebereiche besonders rasch benetzen kann. Dies hat den Vorteil, dass die Schmelzsicherung entsprechend rasch ansprechen kann.

Die Aufnahmebereiche sind bevorzugt zusammen mindestens ebenso groß wie der von Lotmaterial bedeckte Leiterplattenbereich zwischen den beiden Metallflächen. Diese Maßnahme hat den Vorteil, dass Lotmaterial, das die Leiterplatte zwischen den beiden Metallflächen bedeckt, bei Ansprechen der Sicherung weitgehend vollständig in die Aufnahmebereiche wandern kann.

Unter einem Weichlotmaterial ist gemäß dem üblichen technischen Sprachgebrauch Lotmaterial zu verstehen, dessen Schmelzpunkt weniger als 450°C beträgt. Bevorzugt wird Lotmaterial mit einem deutlich tieferen Schmelzpunkt, beispielsweise weniger als 250°C, insbesondere weniger als 200 °C, verwendet. Geeignet sind beispielsweise Zinnlegierungen, insbesondere Zinn-Bleilegierungen und/oder Indiumlegierungen.

Weitere Einzelheiten und Vorteile der Erfindung werden an Ausführungsbeispielen der Erfindung unter Bezugnahme auf die beigefügten Zeichnungen erläutert. Gleiche und einander entsprechende Teile sind dabei mit übereinstimmenden Bezugszahlen bezeichnet. Es zeigen:
- Figur 1: eine schematische Darstellung einer Schmelzsicherung,
- Figur 2: die durch Lotmaterial überbrückten Metallflächen von Figur 1;
- Figur 3: eine Seitenansicht zu Figur 1;
- Figur 4: die in Figur 1 dargestellte Schmelzsicherung im ausgelösten Zustand;
- Figur 5: ein weiteres Ausführungsbeispiel einer Schmelzsicherung im ausgelösten Zustand; und
- Figur 6: eine Schnittansicht zu Figur 5.

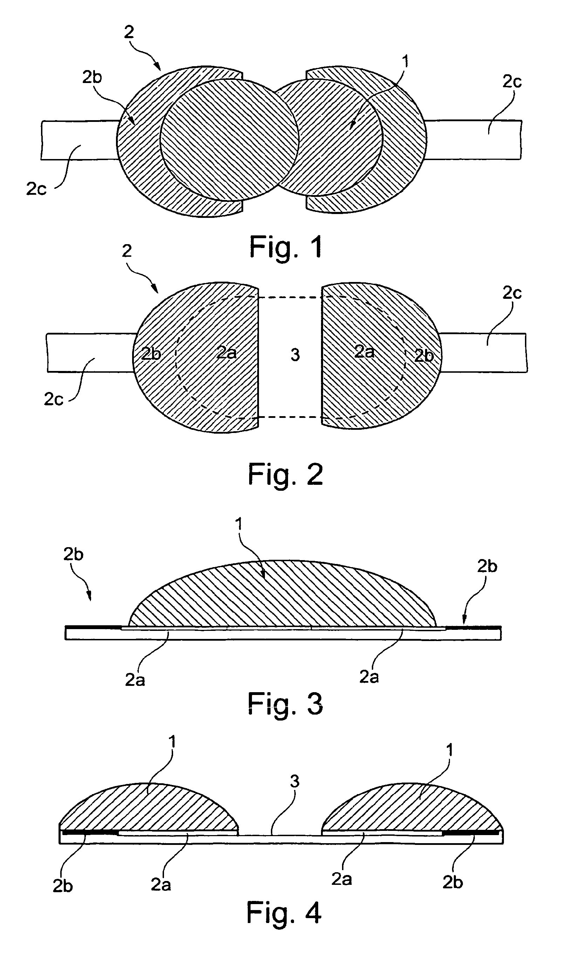

In Figur 1 ist schematisch der Aufbau eines Ausführungsbeispiels einer erfindungsgemäßen Schmelzsicherung dargestellt. Die Schmelzsicherung wird von Weichlotmaterial 1, beispielsweise L-Sn60PbAg oder einer Indiumlegierung, gebildet, das jeweils einen Kontaktbereich 2a von zwei Metallflächen 2 bedeckt und einen dazwischen liegenden Abstand überbrückt. Wie Figur 1 zeigt, bedeckt das Weichlotmaterial 1 jeweils nur einen Teil der beiden Metallflächen 2. Ein an den von Weichlotmaterial 1 bedeckten Kontaktbereich 2a angrenzender Teilbereich 2b ist frei von Lotmaterial 1 und bildet einen Aufnahmebereich, die bei einem Ansprechen der Sicherung mit geschmolzenem Lotmaterial 1 benetzt wird.

In Figur 2 sind die Metallflächen 2 des in Figur 1 dargestellten Ausführungsbeispiels ohne Lotmaterial 1 dargestellt. In den Metallflächen 2 sind dabei die von Weichlotmaterial 1 bedeckten Kontaktbereiche 2a und die nicht von Weichlotmaterial bedeckten Aufnahmebereiche 2b eingezeichnet.

Bei einem Schmelzen des Lotmaterials 1 werden die Aufnahmebereiche 2b von dem Lotmaterial 1 benetzt. Dies führt dazu, dass Lotmaterial 1 aus dem Leiterplattenbereich 3 zwischen den beiden Metallflächen 2 abgezogen und der von dem Lotmaterial 1 gebildete elektrische Kontakt unterbrochen wird.

Figur 3 zeigt schematisch eine Seitenansicht zu Figur 1. Figur 4 zeigt eine entsprechende Seitenansicht nach Auslösen der Schmelzsicherung. Im ausgelösten Zustand benetzt das Lotmaterial 1 die Aufnahmebereiche 2b, welche die Kontaktbereiche 2a umgeben. Der zwischen den beiden Metallflächen 2 liegende Abschnitt 3 der Leiterplattenoberfläche ist im ausgelösten Zustand der Schmelzsicherung weitgehend frei von Lotmaterial 1.

Zur Herstellung der in Figur 1 dargestellten Schmelzsicherung werden zunächst die für die Aufnahmebereiche 2b vorgesehenen Teilflächen der Metallflächen 2 mit einer lotabweisenden Schutzschicht, beispielsweise Lötstopplack, bedeckt. Anschließend werden die als Kontaktbereiche 2a vorgesehenen Teile der Metallflächen 2, die nicht von der lotabweisenden Schutzschicht bedeckt sind, mit flüssigem Lotmaterial 1 bedeckt. Mit dem dabei aufgebrachten Lotmaterial 1 wird auch der zwischen den Kontaktbereichen 2a vorhandene Abstand 3 auf der Leiterplattenoberfläche überbrückt, so dass die beiden Metallflächen 2 durch das Lotmaterial 1 elektrisch leitend verbunden sind. Nach dem Erstarren des Lotmaterials 1 wird die Schutzschicht von den Aufnahmebereichen 2b entfernt.

Um die Benetzbarkeit der Aufnahmebereiche 2b zu verbessern, können diese teilweise oder vollständig mit Flussmittel bedeckt sein. Die Metallflächen 2 sind aus für Leiterbahnen gebräuchlichem Material, beispielsweise Kupfer mit eventuellen Beschichtungen. Die Aufnahmebereiche 2b und die Kontaktbereiche 2a sind bei dem dargestellten Ausführungsbeispiel zusammen als verbreiterte Endabschnitte von Leiterbahnen 2c ausgebildet. Der von Lotmaterial 1 bedeckte Leiterplattenbereich 3 zwischen den beiden Metallflächen 2 kann beispielsweise aus einem für Leiterplatten gebräuchlichen Epoxidharz bestehen.

Die Aufnahmebereiche 2b umgeben die Kontaktbereiche 2a U- oder C-förmig. Beim Auslösen der Sicherung kann deshalb geschmolzenes Lotmaterial 1 über eine vorteilhaft große Umfangsfläche in die Aufnahmebereiche 2b hineinfließen. Die Aufnahmebereiche 2b sind bevorzugt zusammen größer als die von Lotmaterial 1 bedeckte Oberfläche 3 zwischen den beiden Metallflächen 2. Auf diese Weise steht genug Platz zur Verfügung, um bei einem Auslösen der Sicherung das den Abstand 3 zwischen den beiden Metallflächen 2 überbrückende Lotmaterial 1 aufzunehmen. In der schematischen Darstellung der Figur 1 erscheinen die Aufnahmebereiche 2b etwas kleiner als die von ihnen umgebenen Kontaktbereiche 2a. Bevorzugt sind die Aufnahmebereiche 2b aber mindestens eben so groß wie die von ihnen umgebenen Kontaktbereiche 2a.

Die vorstehend erläuterte Schmelzsicherung kann beispielsweise verwendet werden, um bei einem Defekt eines auf der Leiterplatte angeordneten Feldeffekttransistors, insbesondere eines MOSFETs, einen Laststrom zu unterbrechen. Die Schmelzsicherung wird zu diesem Zweck thermisch an den Feldeffekttransistor gekoppelt, beispielsweise indem sie in unmittelbarer Nähe des Transistors angeordnet wird. Ein von dem Feldeffekttransistor zu schaltender Laststrom fließt im Betrieb durch die Schmelzsicherung. Im Fehlerfall führt eine Erwärmung des Feldeffekttransistors zu einem Aufschmelzen des Lotmaterials 1, das daraufhin die Aufnahmebereiche 2b benetzt und dabei aus dem Raum zwischen den beiden Konaktbereichen 2a abfließt, so dass die Sicherung anspricht und ein elektrischer Kontakt zwischen den beiden Metallflächen 2 unterbrochen wird.

Bei dem in den Figuren 1 bis 4 dargestellten Ausführungsbeispiel haben die beiden Metallflächen 2 an ihren einander zugewandten Seiten jeweils einen geradlinig verlaufenden Rand. Daneben sind jedoch auch andere Formen möglich. Beispielsweise kann einer der beiden Kontaktbereiche 2a an seinem Rand eine Einbuchtung haben, in die der andere Kontaktbereich 2a mit einem an seinem Rand ausgebildeten Vorsprung hineinragt. Insbesondere können die Kontaktbereiche 2a verzahnt ineinander greifen.

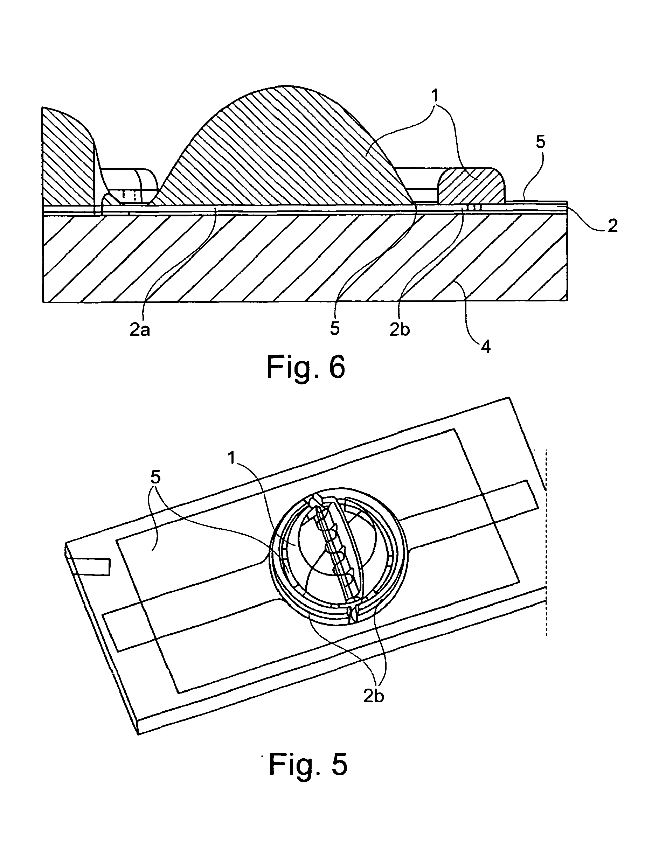

Ein entsprechendes Ausführungsbeispiel einer Schmelzsicherung ist schematisch in den Figuren 5 im ausgelösten Zustand dargestellt. Figur 6 zeigt dazu eine Schnittansicht eines Details von Figur 5. Die beiden mit Lotmaterial 1 bedeckten Kontaktbereiche 2a greifen bei dem in Figur 5 dargstellten Ausführungsbeispiel mäanderförmig ineinander. Die Kontaktbereiche 2a sind von C-förmigen Aufnahmebereichen 2b umgeben, die ebenfalls mit Lotmaterial 1 bedeckt sind, da die Sicherung im ausgelösten Zustand dargestellt ist.

Eine Besonderheit des in den Figuren 5 und 6 dargestellten Ausführungsbeispiels besteht darin, dass die lotabweisende Schutzschicht 5 nicht vollständig von den Metallflächen 2 entfernt wurde, sondern weiterhin Teilflächen zwischen dem Kontaktbereich 2a und dem Aufnahmebereich 2b bedeckt. Die Schutzschicht 5 wurde bei diesem Ausführungsbeispiel lediglich in einigen Durchgangsbereichen entfernt, welche die Aufnahmebereiche 2b mit den Kontaktbereichen 2a verbinden.

In Figur 6 sind die Leiterplatte 4, die auf ihr angeordneten Metallflächen 2, das Lotmaterial 1 und die Schutzschicht 5, welche bei dem in Figur 5 dargestellten Ausführungsbeispiel nicht vollständig von den Metallflächen 2 entfernt wurde, dargestellt.

In Figur 6 ist das Lotmaterial 1 schematisch dargestellt. Tatsächlich ergibt sich beim Aufschmelzen und anschließenden Erstarren von Lotmaterial eine näherungsweise symmetrische Kuppelform eines Lottropfens. In Figur 6 sind einige der Flanken des Lotmaterials 1 übertrieben steil dargestellt.

### Bezugszahlen

- 1: Lotmaterial
- 2: Metallflächen
- 2a: Kontaktbereich
- 2b: Aufnahmebereich
- 2c: Leiterbahn
- 3: Leiterplattenoberfläche zwischen den Metallflächen
- 4: Leiterplatte
- 5: Schutzschicht

## Patentansprüche

1. Verfahren zum Ausbilden einer Schmelzsicherung, die zwei nebeneinander auf einer Leiterplatte (5) in einem Abstand voneinander angeordnete Metallflächen (2) elektrisch verbindet,
**dadurch gekennzeichnet, dass**
die beiden Metallflächen (2) jeweils teilweise mit einer Schutzschicht (5) bedeckt werden, wobei eine einen Kontaktbereich (2a) bildende Teilfläche unbedeckt bleibt,
auf die beiden unbedeckten Teilflächen (2a) flüssiges Weichlotmaterial (1) aufgebracht wird, das den Abstand zwischen den beiden Metallflächen (2) überbrückt, und die Leiterplatte (5) bedeckt und
nach Erstarren des Weichlotmaterials (1) die Schutzschicht (5) in der Umgebung des Lotmaterials (1) entfernt wird, um Aufnahmebereiche (2b) zu bilden, die bei einem Schmelzen des Lotmaterials (1) von diesem benetzt werden, so dass Lotmaterial (1) aus einem Leiterplattenbereich (3) zwischen den beiden Metallflächen (2) abfließt und der von dem Lotmaterial (1) gebildete elektrische Kontakt unterbrochen wird.

2. Verfahren nach einem der vorstehenden Ansprüche, **dadurch gekennzeichnet, dass** auf die beiden Metallflächen (2) Flussmittel aufgebracht wird.

3. Verfahren nach einem der vorstehenden Ansprüche, **dadurch gekennzeichnet, dass** die Schutzschicht (5) so aufgebracht wird, dass sie den Kontaktbereich (2a) umgibt, vorzugsweise bogenförmig umgibt.

4. Leiterplatte mit einer Schmelzsicherung, die zwei Metallflächen (2), die nebeneinander in einem Abstand voneinander angeordnet sind, elektrisch leitend verbindet, wobei die Schmelzsicherung durch Weichlotmaterial (1) gebildet ist, das jeweils einen Kontaktbereich (2a) der beiden Metallflächen (2) bedeckt und den dazwischen liegenden Abstand überbrückt,
ein an den Kontaktbereich (2a) angrenzender Teilbereich (2b) von wenigstens einer der Metallflächen (2) frei von Lotmaterial (1) ist und einen von geschmolzenem Lotmaterial (1) benetzbareren Aufnahmebereich bildet, der bei einem Schmelzen des Lotmaterials (1) von diesem benetzt wird, so dass Lotmaterial (1) aus einem Leiterplattenbereich (3) zwischen den beiden Metallflächen (2) abgezogen und der von dem Lotmaterial (1) gebildete elektrische Kontakt unterbrochen wird, **dadurch gekennzeichnet, dass**
das Weichlotmaterial (1) der Schmelzsicherung die Leiterplattenoberfläche zwischen den beiden Metallflächen (2) bedeckt, wobei die Grenzflächenengergie zwischen dem Weichlotmaterial (1) und dem Aufnahmebereich geringer ist als die Grenzflächenenergie zwischen dem Weichlotmaterial (1) und der Leiterplattenoberfläche zwischen den beiden überbrückten Metallflächen (2).

5. Leiterplatte nach Anspruch 4, **dadurch gekennzeichnet, dass** bei beiden Metallflächen (2) ein an den Kontaktbereich (2a) angrenzender Teilbereich frei von Lotmaterial (1) ist und ein Aufnahmebereich (2b) für geschmolzenes Lotmaterial (1) bildet.

6. Leiterplatte nach Anspruch 4 oder 5, **dadurch gekennzeichnet, dass** die Aufnahmebereiche (2b) die Kontaktbereiche (2a) umschließen.

7. Leiterplatte nach einem der Ansprüche 4 bis 6, **dadurch gekennzeichnet, dass** die Aufnahmebereiche (2b) die Kontaktbereiche (2a) U- oder C-förmig umschließen.

8. Leiterplatte nach einem der Ansprüche 4 bis 7, **dadurch gekennzeichnet, dass** der Aufnahmebereich (2b) zumindest teilweise mit Flussmittel bedeckt ist.

9. Leiterplatte nach einem der Ansprüche 4 bis 8, **dadurch gekennzeichnet, dass** die Aufnahmebereiche (2b) zusammen mindestens ebenso groß wie der von Lotmaterial (1) bedeckte Leiterplattenbereich (3) zwischen den beiden Kontaktbereichen (2a) ist.

10. Leiterplatte nach einem der Ansprüche 4 bis 9, **dadurch gekennzeichnet, dass** die Aufnahmebereiche (2b) zusammen mindestens ebenso groß wie die Fläche der beiden Kontaktbereiche (2a) zusammen ist.

11. Leiterplatte nach einem der Ansprüche 4 bis 10, **dadurch gekennzeichnet, dass** wenigstens einer der Kontaktbereiche (2a) an seinem Rand eine Einbuchtung hat, in die der andere Kontaktbereich (2a) mit einem an seinem Rand ausgebildeten Vorsprung hineinragt.

12. Leiterplatte nach einem der Ansprüche 4 bis 11, **dadurch gekennzeichnet, dass** jeder der beiden Aufnahmebereiche (2b) größer als die Fläche des von ihm umgebenen Kontaktbereiches ist.

13. Leiterplatte nach einem der Ansprüche 4 bis 12, **dadurch gekennzeichnet, dass** die Leiterplatte zwischen den beiden Kontaktbereichen (2a) eine von dem Weichlotmaterial (1) bedeckte Oberfläche aus Kunstharz aufweist.

14. Leiterplatte nach einem der Ansprüche 4 bis 13, **dadurch gekennzeichnet, dass** die Leiterplatte einen thermisch mit der Schmelzsicherung gekoppelten Feldeffekttransistor zum Schalten eines durch die Schmelzsicherung fließenden Stromes trägt.

15. Leiterplatte nach einem der Ansprüche 4 bis 14, **dadurch gekennzeichnet, dass** der Aufnahmebereich (2a) an einem verbreiterten Ende einer Leiterbahn (2c) ausgebildet ist.

## Claims

1. A method for forming a fuse which electrically connects two metal surfaces (2) that are arranged on a printed circuit board (5) next to each other and spaced apart from each other,
**characterized in that**
the two metal surfaces (2) are each partially covered with a protective coating (5), wherein a partial region forming a contact region (2a) remains uncovered,
liquid soft solder material (1) which bridges the gap between the two metal surfaces (2) and covers the printed circuit board (5) is applied onto the two uncovered partial regions (2a), and
after the soft solder material (1) has solidified, the protective coating (5) in a surrounding area of the solder material (1) is removed to form receiving regions (2b) which are wetted by the solder material (1) when the latter melts, with the result that solder material (1) flows off from a printed circuit board region (3) between the two metal surfaces (2) and the electrical contact formed by the solder material (1) is interrupted.

2. The method according to Claim 1, **characterized in that** flux is applied onto the two metal surfaces (2).

3. The method according to any one of the preceding claims, **characterized in that** the protective coating (5) is applied such that it surrounds the contact region (2a), preferably in the form of a bend.

4. A printed circuit board with a fuse which connects two metal surfaces (2) in an electrically conducting manner, said metal surfaces (2) being arranged next to each other and spaced apart from each other, wherein the fuse is formed by a soft solder material (1) which covers a contact region (2a) of each of the two metal surfaces (2) and bridges the gap therebetween,
a partial region (2b) of at least one of the metal surfaces (2) that is arranged adjacent to the contact region (2a) is free from solder material (1) and forms a receiving region that can be wetted by molten solder material (1), said receiving region being wetted by the solder material (1) when the latter melts, with the result that solder material (1) is drawn off from a printed circuit board region (3) between the two metal surfaces (2) and the electrical contact formed by the solder material (1) is interrupted, **characterized in that**
the soft solder material (1) of the fuse covers the surface of the printed circuit board (4) between the two metal surfaces (2), wherein the interface energy between the soft solder material (1) and the receiving region is lower than the interface energy between the soft solder material (1) and the surface of the printed circuit board (4) between the two metal surfaces (2).

5. The printed circuit board according to Claim 4, **characterized in that**, on both metal surfaces (2), a partial region adjacent to the contact region (2a) is free from solder material (1) and forms a receiving region (2b) for molten solder material (1).

6. The printed circuit board according to Claim 4 or 5, **characterized in that** the receiving regions (2b) enclose the contact regions (2a).

7. The printed circuit board according to any one of Claims 4 to 6, **characterized in that** the receiving regions (2b) enclose the contact regions (2a) in the shape of a U or a C.

8. The printed circuit board according to any one of Claims 4 to 7, **characterized in that** the receiving region (2b) is covered with flux at least in part.

9. The printed circuit board according to any one of Claims 4 to 8, **characterized in that**, together, the receiving regions (2b) are at least as large as the printed circuit board region (3) between the two contact regions (2a) that is covered with solder material (1).

10. The printed circuit board according to any one of Claims 4 to 9, **characterized in that**, together, the receiving regions (2b) are at least as large as the area of the two contact regions (2a) taken together.

11. The printed circuit board according to any one of Claims 4 to 10, **characterized in that** at least one of the contact regions (2a) has an indentation on its edge, with the other contact region (2a) projecting into said indentation with a bulge formed on its edge.

12. The printed circuit board according to any one of Claims 4 to 11, **characterized in that** each of the two receiving regions (2b) is larger than the area of the contact region surrounded thereby.

13. The printed circuit board according to any one of Claims 4 to 12, **characterized in that**, between the two contact regions (2a), the printed circuit board comprises a surface of synthetic resin that is covered with the soft solder material (1).

14. The printed circuit board according to any one of Claims 4 to 13, **characterized in that** the printed circuit carries a field-effect transistor that is thermally coupled to the fuse and is intended to switch a current flowing through the fuse.

15. The printed circuit board according to any one of Claims 4 to 14, **characterized in that** the receiving region (2a) is formed at a broadened end of a track (2c).

## Revendications

1. Procédé pour la formation d'un fusible reliant électriquement deux surfaces métalliques (2) agencées côte à côte à distance l'une de l'autre sur une carte imprimée (5),
**caractérisé en ce que**
les deux surfaces métalliques (2) sont respectivement recouvertes partiellement d'une couche protectrice (5), où une surface partielle formant une région de contact (2a) demeure découverte,
**en ce qu'**un matériau de brasage tendre liquide (1) pontant l'espace entre les deux surfaces métalliques (2) et recouvrant la carte imprimée (5) est appliqué sur les deux surfaces partielles (2a) découvertes, et suite à la solidification du matériau de brasage tendre (1), la couche protectrice (5) est retirée autour du matériau de brasage (1) pour former des régions de réception (2b) qui, lors d'une fusion du matériau de brasage (1), sont arrosées par celui-ci, de manière à ce que le matériau de brasage (1) s'écoule à partir d'une région de carte imprimée (3) entre les deux surfaces métalliques (2) et à ce que le contact électrique formé par le matériau de brasage (1) soit interrompu.

2. Procédé selon l'une des revendications précédentes, **caractérisé en ce qu'**un flux est appliqué sur les deux surfaces métalliques (2).

3. Procédé selon l'une des revendications précédentes, **caractérisé en ce que** la couche protectrice (5) est appliquée de manière à entourer la région de contact (2a), de préférence en formant un arc.

4. Carte imprimée avec un fusible reliant de façon électriquement conductrice deux surfaces métalliques (2) agencées côte à côte à distance l'une de l'autre, dans laquelle le fusible est formé par un matériau de brasage tendre (1) recouvrant respectivement une région de contact (2a) des deux surfaces métalliques (2) et pontant l'espace entre celles-ci,
une région partielle (2b) d'au moins l'une des surfaces métalliques (2), adjacente à la région de contact (2a), est exempte de matériau de brasage (1) et forme une région de réception susceptible d'être arrosée de matériau de brasage (1) fondu, qui est arrosée par le matériau de brasage (1) lors d'une fusion de celui-ci, de manière à ce que du matériau de brasage (1) soit retiré à partir d'une région de carte imprimée (3) entre les deux surfaces métalliques (2), et à ce que le contact électrique formé par le matériau de brasage (1) soit interrompu, **caractérisée en ce que**
le matériau de brasage tendre (1) du fusible recouvre la surface de la carte imprimée entre les deux surfaces métalliques (2), l'énergie interfaciale entre le matériau de brasage tendre (1) et la région de réception étant inférieure à l'énergie interfaciale entre le matériau de brasage tendre (1) et la surface de la carte imprimée entre les deux surfaces métalliques (2) pontées.

5. Carte imprimée selon la revendication 4, **caractérisée en ce que** sur les deux surfaces métalliques (2), une région partielle adjacente à la région de contact (2a) est exempte de matériau de brasage (1) et forme une région de réception (2b) pour le matériau de brasage (1) fondu.

6. Carte imprimée selon la revendication 4 ou 5, **caractérisée en ce que** les régions de réception (2b) entourent les régions de contact (2a).

7. Carte imprimée selon l'une des revendications 4 à 6, **caractérisée en ce que** les régions de réception (2b) entourent les régions de contact (2a) en forme de U ou de C.

8. Carte imprimée selon l'une des revendications 4 à 7, **caractérisée en ce que** la région de réception (2b) est au moins partiellement recouverte de flux.

9. Carte imprimée selon l'une des revendications 4 à 8, **caractérisée en ce que** les régions de réception (2b) sont conjointement au moins aussi grandes que la région de carte imprimée (3) recouverte de matériau de brasage (1) entre les deux régions de contact (2a).

10. Carte imprimée selon l'une des revendications 4 à 9, **caractérisée en ce que** les régions de réception (2b) sont conjointement au moins aussi grandes que la surface des deux régions de contact (2a).

11. Carte imprimée selon l'une des revendications 4 à 10, **caractérisée en ce qu'**au moins l'une des régions de contact (2a) possède une échancrure sur son bord, dans laquelle l'autre région de contact (2b) s'introduit avec une saillie formée sur son bord.

12. Carte imprimée selon l'une des revendications 4 à 11, **caractérisée en ce que** chacune des deux régions de réception (2b) est plus grande que la surface de la région de contact qu'elle entoure.

13. Carte imprimée selon l'une des revendications 4 à 12, **caractérisée en ce qu'**entre les deux régions de contact (2a), la carte imprimée comporte une surface en résine synthétique recouverte de matériau de brasage tendre (1).

14. Carte imprimée selon l'une des revendications 4 à 13, **caractérisée en ce que** la carte imprimée porte un transistor à effet de champ accouplé thermiquement avec le fusible, pour la commutation d'un courant passant par le fusible.

15. Carte imprimée selon l'une des revendications 4 à 14, **caractérisée en ce que** la région de réception (2a) est formée à une extrémité élargie d'une piste conductrice (2c).
